# EUROPÄISCHE PATENTSCHRIFT

(11) **EP 2 191 704 B1**
(45) Veröffentlichungstag und Bekanntmachung des Hinweises auf die Patenterteilung: **29.12.2010**
(21) Anmeldenummer: 09748012.3
(22) Anmeldetag: 14.08.2009
(51) Int. Cl.: H05K 5/00

(54) **GEHÄUSE FÜR ELEKTRISCHE BAUELEMENTE FÜR EIN GEPANZERTES FAHRZEUG, INSBESONDERE KAMPFFAHRZEUG**
HOUSING FOR ELECTRICAL COMPONENTS FOR AN ARMOURED VEHICLE IN PARTICULAR A FIGHTING VEHICLE
BOÎTIER POUR COMPOSANTS ÉLECTRIQUES D'UN VÉHICULE BLINDÉ, EN PARTICULIER D'UN VÉHICULE DE COMBAT

(30) Priorität: 21.08.2008 DE 102008039026
(43) Veröffentlichungstag der Anmeldung: 02.06.2010
(73) Patentinhaber: Krauss-Maffei Wegmann GmbH & Co. KG, 80997 München (DE)
(72) Erfinder: HAHN, Reinhard, 34305 Niedenstein (DE); FEHR, Michael, 34590 Wabern-Udenborn (DE)
(74) Vertreter: Feder Walter Ebert
(86) Internationale Anmeldenummer: PCT/DE2009/001159
(87) Internationale Veröffentlichungsnummer: WO 2010/020228

(56) Entgegenhaltungen:
- WO-A2-2007/076296
- GB-A- 2 423 645
- US-A1- 2007 145 699

## Beschreibung

Die Erfindung betrifft ein Gehäuse mit einem ballistisch gepanzenten Deckel für elektrische Bauelemente, insbesondere Kondensatoretemente, für ein gepanzertes Fahrzeug, insbesondere Kampffahrzeug, wie es aus der GB-A-2423645 bekannt geworden ist.

Elektrische Bauelemente, wie Kondensatorelemente, werden in der Regel in einem Gehäuse angeordnet, um sie vor äußeren Einflüssen zu schützen. Hierbei muss insbesondere ein Schutz gegen Überhitzen gewährteistet sein, da Wärme zu einem Funktionsversagen oder sogar zu einer Zerstörung der elektrischen Bauelemente führen kann.

Bei einem Fahrzeug, insbesondere Kampffahrzeug, ist der zur Verfügung stehende Bauraum stark beschränkt, wobei durch die stetige Zunahme der elektrischen Bauelemente bei modernen Fahrzeugsystemen dieses Problem noch vergrößert wird.

Es ist bekannt, Kondensatoretemente, beispielsweise Doppelschicht-Kondensatoren, die auch Ultra-Caps oder Super-Caps genannt werden, als Pufferspeicher für Energie einzusetzen. Um elektrische Leitungstängen zu reduzieren, sollten die Kondensatoretemente und somit auch das Gehäuse möglichst nahe an der Leistungselektronik des Fahrzeugs angeordnet werden, wodurch eine Wärmeprobtematik entsteht, da eine Leistungselektronik in der Regel eine Wärmequelle darstellt. Bei Fahrzeugen, insbesondere Kampffahrzeugen, tritt zudem das Problem hinzu, dass die Fahrzeuge über einen großen Temperaturbereich in verschiedenen Länderregionen einsetzbar sein sollen, so dass auch das Gehäuse dementsprechend ausgelegt sein muss.

Die Erfindung hat die Aufgabe, ein Gehäuse der eingangs genannten Art derart auszugestalten, dass es an Fahrzeugen, die einen begrenzten Bauraum aufweisen und für einen großen Temperaturbereich ausgelegt sind, verwendet werden kann.

Die Erfindung löst die Aufgabe mit den Merkmalen aus dem kennzeichnenden Teil des Patentanspruchs 1. Vorteilhafte Weiterbildungen sind Bestandteil der abhängigen Ansprüche.

Ein Grundgedanke der Erfindung liegt darin, das Gehäuse derart auszugestalten, dass es in eine Fahrzeugaußenausnehmung einsetzbar ist. Als Fahrzeugaußenausnehmung im Sinne der Erfindung wird eine Ausnehmung der Fahrzeugaußenhaut, beispielsweise des Fahrzeugdaches oder der Fahrzeugseitenwand, verstanden. Da das eingesetzte Gehäuse einen Teil der Fahrzeugaußenhaut darstellt, umfasst das Gehäuse einen Deckel, welcher ballistisch geschützt ist, wobei er hierzu insbesondere eine Panzerplatte vorzugsweise aus Panzerstahl aufweist. Um ein Aufheizen der elektrischen Bauelemente im Gehäuse durch Sonneneinstrahlung zu vermeiden, weist der Deckel zudem einen Wärmeschutz auf. Damit das Gehäuse zudem oberhalb einer Wärmequelle, wie beispielsweise einer Leistungselektronik anordbar ist, ist auch der Boden des Gehäuses mit einer Wärmedämmung versehen. Der Wärmeschutz des Deckels und/oder die Wärmedämmung des Bodens umfassen bevorzugt ein Wärmedämm-Materiat, insbesondere eine Wärmedämmstoffmatte.

Um die Wirkung der Sonneneinstrahlung zu vermindern, kann der Wärmeschutz des Deckels ein Sonnenreftexionsetement umfassen, welches einen hohen Reflexionsgrad der Sonneneinstrahlung aufweist. Um eine Abstrahlung des aufgewärmten Sonnenreflexionselementes in Richtung der elektrischen Bauelemente zu vermeiden, kann unter dem Sonnenreflexionselement eine Wärmedämmstoffmatte angeordnet sein. Um zudem eine Luftzirkulation zu ermöglichen, kann zwischen der ballistischen Panzerung und dem Sonnenreftexionsetement ein Luftspalt vorgesehen werden.

Bei einer besonders bevorzugten Ausgestaltung weist das Gehäuse mindestens zwei Kammern auf, die luftdicht gegeneinander abgeschlossen und mit einer Kabeldurchführung elektrisch verbunden sind. Hierbei kann in einer Kammer mindestens ein Kondensatorelement, vorzugsweise ein Doppelschicht-Kondensator, und in der anderen Kammer die Steuerelektronik für das Kondensatorelement angeordnet werden. Zudem kann insbesondere im Boden der zweiten Kammer eine elektrische Durchführung angeordnet werden, die vorzugsweise mit einem unterseitigen Steckeranschluss versehen ist, so dass die Steuerelektronik mit Elementen im Fahrzeuginnenraum verbindbar ist. Durch die Luftdichtheit der Kammern ist es hierbei möglich, die zweite Kammer gekapselt auszuführen und nur die erste Kammer mit einem abnehmbaren und luftdicht aufzubringenden Deckel zu versehen.

Bevorzugt weist das Gehäuse Montagemittel auf, um es am Fahrzeug in der Fahrzeugaußenausnehmung zu montieren. Besonders bevorzugt umfassen die Montagemittel hierbei einen Montageflansch, so dass das vorzugsweise wannenförmig ausgestattete Gehäuse über den Montageflansch in einfacher Weise mit dem Fahrzeug verbindbar, vorzugsweise verschraubbar ist.

Um die Wirkung gegenüber Überhitzung noch zu verbessern, können auch an den Seitenflächen des Gehäuses Wärmedämmungen, insbesondere Wärmedämmstoffmatten, angeordnet werden.

Die Erfindung umfasst auch ein gepanzertes Fahrzeug, insbesondere Kampffahrzeug, mit einem in eine Fahrzeugaußenausnehmung, insbesondere in eine Fahrzeugdachausnehmung, eingesetztem bereits beschriebenen Gehäuse. Dieses Gehäuse kann oberhalb einer Wärmequelle, insbesondere einer Leistungselektronik, angeordnet sein. Hierdurch ist es möglich, die elektrischen Bauelemente, insbesondere die Kondensatoretemente, so nah wie möglich im Bereich der Leistungselektronik zu platzieren und gleichzeitig vor Erwärmung von innen und von außen sowie vor Beschuss zu schützen. Zudem existiert bei bekannten Fahrzeugen oftmals ein durch einen Deckel abgeschlossener Freiraum zwischen Leistungselektronik und Fahrzeugaußenhaut, welcher durch das Gehäuse nutzbar ist. Das deckelartige Gehäuse kann hierbei den Deckel austauschbar ersetzen. Bevorzugt ist das Gehäuse in eine Ausnehmung eines Geschützturms des Fahrzeugs eingesetzt.

Ein vorteilhaftes Ausführungsbeispiel der Erfindung wird anhand der Figuren 1 bis 3 beschrieben. Es zeigen
- Fig. 1: ein Gehäuse mit elektrischen Bauelementen in einer perspek- tivischen Darstellung mit teilweise ausgeblendeten Elementen;
- Fig. 2: das an einem Fahrzeug angeordnete Gehäuse nach Fig. 1 in einem Querschnitt; und
- Fig. 3: den Turm eines Kampffahrzeugs mit einem Gehäuse nach Fig. 1.

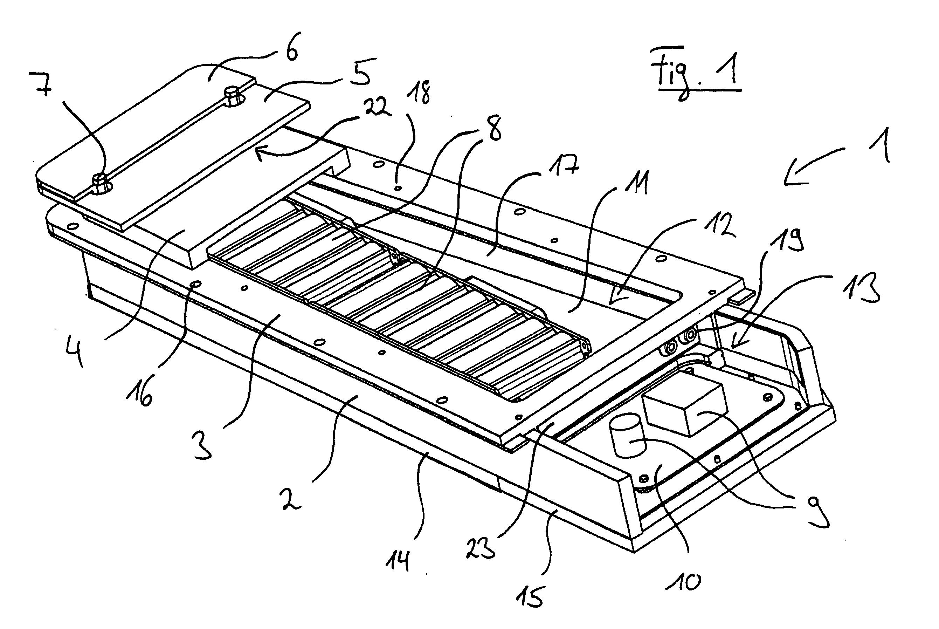

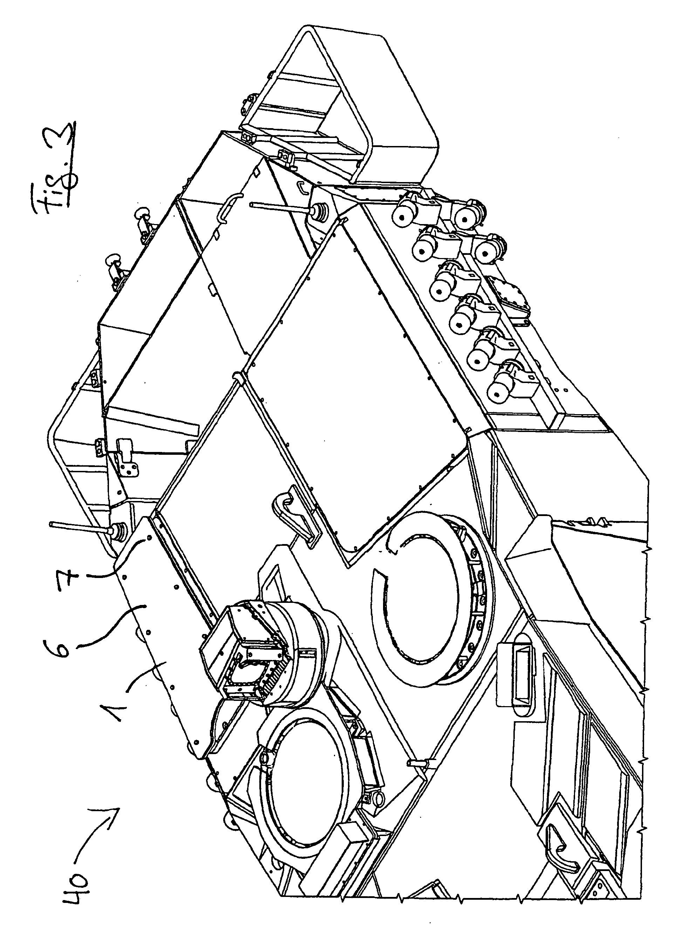

Die Fig. 1 zeigt in einer perspektivischen Darstellung ein Gehäuse 1, welches in eine Fahrzeugaußenausnehmung eines in Fig. 3 dargestellten Turmes 40 eines Kampffahrzeugs einsetzbar ist. Das Gehäuse besteht aus einer Gehäusewanne 2, auf welcher ein Montagedeckel 3 mit einem Montageflansch fest angeordnet ist. Das Gehäuse 1 weist ferner einen Deckel 4 umfassend eine Panzerplatte aus Panzerstahl auf, welcher mit dem Montagedeckel 3 über Bohrungen 18 verschraubbar ist.

Das Gehäuse 1 umfasst zwei Kammern 12 und 13, wobei in der ersten Kammer 12 mehrere als Doppelschicht-Kondensatoren ausgeführte Kondensatorelemente 8 angeordnet sind, die mit einer in der zweiten Kammer 13 angeordneten Steuerelektronik 9, die auf einer Platine 10 angeordnet ist, über zwei Kabeldurchführungen 19 elektrisch verbunden sind, wobei die Kammern 12 und 13 mittels einer Trennwand 23 luftdicht gegeneinander abgeschlossen sind. Die Kondensatoretemente 8 sind in der Gehäusewanne 2 schwingungsgedämpft eingebaut.

Unterhalb des Bodens 11 der Wanne 2 des Gehäuses 1 sind Dämmstoffmatten 14 und 15 angeordnet. Zur Erhöhung des Schutzes gegen Wärme sind zudem auch die Seitenwände 17 der Wanne 2 mit einer Wärmedämmstoffmatte versehen.

Oberhalb des gepanzerten Deckels 4 ist ein Wärmeschutz, bestehend aus einem Sonnenreflexionselement 6 und einer unmittelbar darunter angeordneten Wärmedämmstoffmatte 5, angeordnet. Die Wärmedämmstoffmatte 5 und das Sonnenreflexionselement 6 sind über Abstandshalter 7 mit dem Deckel 4 verbunden, wobei zwischen der Wärmedämmstoffmatte 5 und dem gepanzerten Deckel 4 ein Luftspalt 22 vorliegt.

Der Boden unterhalb der Platine 10 ist mit einer elektrischen Durchführung versehen, wobei auf der Unterseite des Bodens ein nicht dargestellter Steckeranschluss angeordnet ist, so dass die Steuerelektronik 9 mit Elementen im Fahrzeuginnenraum verbindbar ist.

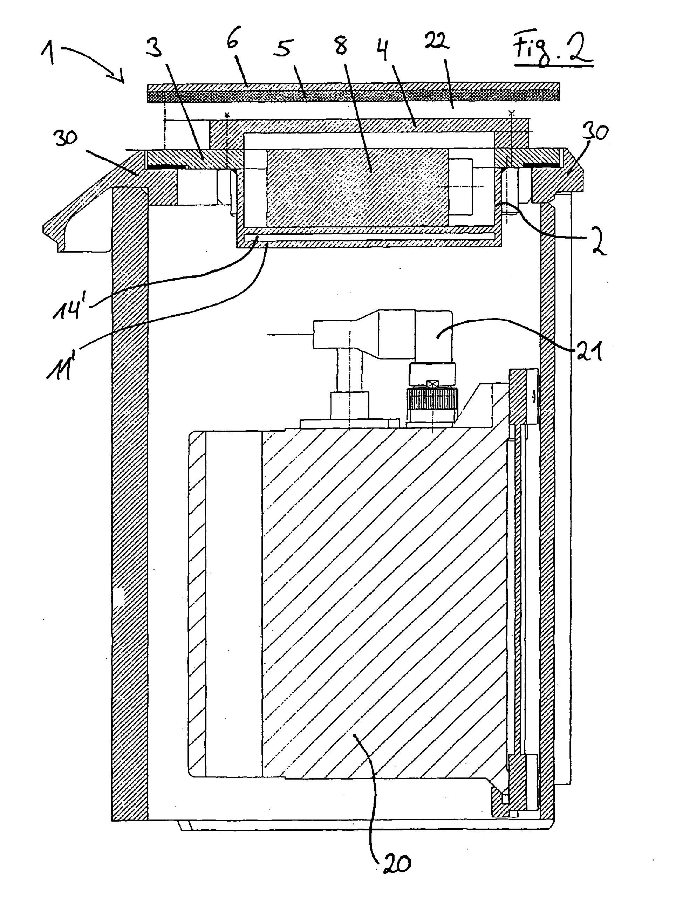

Die Fig. 2 zeigt einen Ausschnitt des Turmdaches, welches eine Fahrzeugaußenausnehmung mit einem Ausnehmungsrand 30 aufweist, in welche das Gehäuse 1 eingesetzt ist, so dass das Gehäuse die Fahrzeugaußenausnehmung und den darunter befindlichen Hohlraum dekketartig verschließt. Unterhalb des Randes 30 ist eine Leistungselektronik 20 mit zugehörigen Anschlüssen 21 angeordnet, welche im Betrieb auf Grund der Verlustwärme eine Wärmequelle darstellt.

Das Gehäuse 1' ist über den Montagedeckel 3 mittels der Bohrungen 16 am Rand 30 der Fahrzeugaußenausnehmung verschraubt. In Abwandlung zum Gehäuse 1 nach Fig. 1 ist der Boden 11' doppelwandig ausgeführt, wobei im entstehenden Zwischenraum 14' ein Wärmedämm-Material angeordnet ist.

Wie aus den Fig. 2 und 3 ersichtlich, kann das Gehäuse 1 mit den elektrischen Bauelementen auch als Nachrüstsatz in vorhandene Fahrzeuge mit einer bestehenden Fahrzeugaußenausnehmung und ausreichendem Bauraum unterhalb der Fahrzeugaußenausnehmung eingebaut werden. Dies ist insbesondere bei Doppelschicht-Kondensatoren vorteilhaft, da diese als Energiepufferspeicher erst in jüngerer Vergangenheit Einsatz finden, so dass durch die Erfindung eine einfache Nachrüstung älterer Fahrzeuge möglich ist.

### Bezugszeichenliste:

- 1: Gehäuse
- 2: Gehäusewanne
- 3: Montagedeckel
- 4: gepanzerter Deckel
- 5: Wärmedämmstoffmatte
- 6: Sonnenreflexionselement
- 7: Abstandshalter
- 8: Kondensatorelemente
- 9: Steuerelektronik
- 10: Platine
- 11: Boden
- 12: erste Kammer
- 13: zweite Kammer
- 14: Wärmedämmstoffmatte
- 15: Wärmedämmstoffmatte
- 16: Bohrung
- 17: Seitenwand
- 18: Bohrung
- 19: Kabeldurchführung
- 20: Leistungselektronik
- 21: Anschlusselemente
- 22: Luftspalt
- 23: Trennwand
- 30: Rand der Fahrzeugaußenausnehmung
- 40: Geschützturm eines Kampffahrzeugs

## Patentansprüche

1. Gehäuse mit einem ballistisch gepanzerten Deckel (4) für elektrische Bauelemente (8, 9), insbesondere Kondensatorelemente (8), für ein gepanzertes Fahrzeug, insbesondere Kampffahrzeug, **dadurch gekennzeichnet, dass** es in eine Fahrzeugaußenausnehmung einsetzbar ist und einen Boden (11) mit einer Wärmedämmung (14, 15) aufweist und dass der Deckel (4) einem Wärmeschutz (5, 6, 22) aufweist.

2. Gehäuse nach Anspruch 1, **dadurch gekennzeichnet, dass** der Deckel (4) eine Panzerplatte, insbesondere aus Panzerstahl umfasst.

3. Gehäuse nach einem der vorhergehenden Ansprüche, **dadurch gekennzeichnet, dass** der Wärmeschutz des Deckels (4) und/oder die Wärmedämmung des Bodens (11) ein Wärmedämmmateriat, insbesondere eine Wärmedämmstoffmatte (5, 14, 15), umfasst.

4. Gehäuse nach einem der vorhergehenden Ansprüche, **dadurch gekennzeichnet, dass** der Wärmeschutz des Deckels (4) ein Sonnenreflexionselement (6) umfasst.

5. Gehäuse nach Anspruch 4, **dadurch gekennzeichnet, dass** unter dem Sonnenreflexionselement (6) eine Wärmedämmstoffmatte (5) angeordnet ist.

6. Gehäuse nach Anspruch 2 und Anspruch 4 oder 5, **dadurch gekennzeichnet, dass** zwischen der ballistischen Panzerung (4) und dem Sonnenreftexionselement (6) ein Luftspalt (22) zur Luftzirkulation ist.

7. Gehäuse nach einem der vorhergehenden Ansprüche, **dadurch gekennzeichnet, dass** es zwei Kammern (12, 13) aufweist, die luftdicht gegeneinander abgeschlossen und mit einer Kabeldurchführung (19) elektrisch verbunden sind.

8. Gehäuse nach Anspruch 7, **dadurch gekennzeichnet, dass** in der einen Kammer (12) mindestens ein Kondensatorelement (8), insbesondere ein Doppelschicht-Kondensator, und in der anderen Kammer (13) die Steuerelektronik (9) für das Kondensatorelement (8) angeordnet ist.

9. Gehäuse nach einem der vorhergehenden Ansprüche, **dadurch gekennzeichnet, dass** durch den Boden (11) eine elektrische Durchführung geführt ist, die insbesondere mit einem unterseitigen Steckeranschluss versehen ist.

10. Gehäuse nach einem der vorhergehenden Ansprüche, **dadurch gekennzeichnet, dass** es Montagemittel (3, 16), insbesondere einen Montageflansch, zur Montage am Fahrzeug aufweist.

11. Gehäuse nach einem der vorhergehenden Ansprüche, **dadurch gekennzeichnet, dass** es wannenförmig ausgestaltet ist.

12. Gehäuse nach einem der vorhergehenden Ansprüche, **dadurch gekennzeichnet, dass** es an den Seiten eine Wärmedämmung, insbesondere Wärmedämmstoffmatten, aufweist.

13. Gepanzertes Fahrzeug, insbesondere Kampffahrzeug, mit einem in eine Fahrzeugaußenausnehmung, insbesondere in eine Fahrzeugdachausnehmung oder Fahrzeugturmausnehmung, eingesetzten Gehäuse (1) nach einem der vorhergehenden Ansprüche.

14. Fahrzeug nach Anspruch 13, **dadurch gekennzeichnet, dass** das Gehäuse (1) oberhalb einer Wärmequelle, insbesondere einer Leistungselektronik (20), angeordnet ist.

15. Fahrzeug nach Anspruch 13 oder 14, **dadurch gekennzeichnet, dass** das Gehäuse (1) die Fahrzeugaußenausnehmung deckelartig verschließt.

## Claims

1. Housing with a ballistic armour-plated lid (4) for electrical components (8, 9), in particular capacitor elements (8), for an armoured vehicle, in particular a combat vehicle, **characterized in that** it is insertable into a vehicle external recess and has a base (11) with thermal insulation (14, 15) and that the lid (4) has thermal protection (5, 6, 22).

2. Housing according to claim 1, **characterized in that** the lid (4) comprises an armour plate, in particular of armoured steel.

3. Housing according to one of the preceding claims, **characterized in that** the thermal protection of the lid (4) and/or the thermal insulation of the base (11) comprises a heat-insulating material, in particular a mat of heat-insulating material (5, 14, 15).

4. Housing according to one of the preceding claims, **characterized in that** the thermal protection of the lid (4) comprises a solar reflection element (6).

5. Housing according to claim 4, **characterized in that** a mat of heat-insulating material (5) is disposed under the solar reflection element (6).

6. Housing according to claim 2 and claim 4 or 5, **characterized in that** between the ballistic armour plating (4) and the solar reflection element (6) is an air gap (22) for air circulation.

7. Housing according to one of the preceding claims, **characterized in that** it has two chambers (12, 13) that are hermetically sealed off from one another and electrically connected by a cable bushing (19).

8. Housing according to claim 7, **characterized in that** in the one chamber (12) at least one capacitor element (8), in particular a double layer capacitor, and in the other chamber (13) the control electronics (9) for the capacitor element (8) are disposed.

9. Housing according to one of the preceding claims, **characterized in that** extending through the base (11) is an electrical bushing that in particular is provided with an underside plug connection.

10. Housing according to one of the preceding claims, **characterized in that** it has assembly means (3, 16), in particular an assembly flange, for assembly on the vehicle.

11. Housing according to one of the preceding claims, **characterized in that** it is of a trough-shaped configuration.

12. Housing according to one of the preceding claims, **characterized in that** it has thermal insulation, in particular mats of heat-insulating material, on the sides.

13. Armoured vehicle, in particular a combat vehicle, having a housing (1) according to one of the preceding claims that is inserted into a vehicle external recess, in particular into a vehicle roof recess or vehicle door recess.

14. Vehicle according to claim 13, **characterized in that** the housing (1) is disposed above a heat source, in particular above power electronics (20).

15. Vehicle according to claim 13 or 14, **characterized in that** the housing (1) closes the vehicle external recess in a lid-like manner.

## Revendications

1. Boîtier doté d'un couvercle (4) blindé au plan balistique pour des composants (8, 9) électriques, en particulier des éléments de condensateur (8), pour un véhicule blindé, en particulier un véhicule de combat, **caractérisé en ce qu'**il peut être inséré dans une cavité extérieure du véhicule et présente un fond (11) avec une isolation thermique (14, 15) et **en ce que** le couvercle (4) présente une protection thermique (5, 6, 22).

2. Boîtier selon la revendication 1, **caractérisé en ce que** le couvercle (4) comporte une plaque blindée, en particulier à base d'acier blindé.

3. Boîtier selon l'une quelconque des revendications précédentes, **caractérisé en ce que** la protection thermique du couvercle (4) et/ou l'isolation thermique du fond (11) comprend un matériau calorifuge, en particulier une natte en matériau calorifuge (5, 14, 15).

4. Boîtier selon l'une quelconque des revendications précédentes, **caractérisé en ce que** la protection thermique du couvercle (4) comprend un élément de réflexion solaire (6).

5. Boîtier selon la revendication 4, **caractérisé en ce qu'**une natte en matériau calorifuge (5) est disposée au-dessous de l'élément de réflexion solaire (6).

6. Boîtier selon la revendication 2 et les revendications 4 ou 5, **caractérisé en ce qu'**une fente d'aération (22) pour la circulation de l'air est disposée entre le blindage (4) balistique et l'élément de réflexion solaire (6).

7. Boîtier selon l'une quelconque des revendications précédentes, **caractérisé en ce qu'**il présente deux chambres (12, 13) qui sont fermées de façon hermétique l'une par rapport à l'autre et sont reliées électriquement par un passage de câble (19).

8. Boîtier selon la revendication 7, **caractérisé en ce qu'**au moins un élément de condensateur (8), en particulier un condensateur à double couche, est disposé dans l'une des chambres (12) et l'électronique de commande (9) pour l'élément de condensateur (8) est disposé dans l'autre chambre (13).

9. Boîtier selon l'une quelconque des revendications précédentes, **caractérisé en ce qu'**un passage électrique, qui est doté en particulier d'un branchement de fiche côté inférieur, est guidé à travers le sol (11).

10. Boîtier selon l'une quelconque des revendications précédentes, **caractérisé en ce qu'**il présente des moyens de montage (3, 16), en particulier une bride de montage, pour le montage sur le véhicule.

11. Boîtier selon l'une quelconque des revendications précédentes, **caractérisé en ce qu'**il est conçu en forme de cuve.

12. Boîtier selon l'une quelconque des revendications précédentes, **caractérisé en ce qu'**il présente sur les côtés une isolation thermique, en particulier des nattes en matériau calorifuge.

13. Véhicule blindé, en particulier véhicule de combat, doté d'un boîtier (1) inséré dans une cavité extérieure du véhicule, en particulier dans une cavité de toit de véhicule ou cavité de tourelle de véhicule, selon l'une quelconque des revendications précédentes.

14. Véhicule selon la revendication 13, **caractérisé en ce que** le boîtier (1) est disposé au-dessus d'une source de chaleur, en particulier une électronique de puissance (20).

15. Véhicule selon la revendication 13 ou 14, **caractérisé en ce que** le boîtier (1) verrouille la cavité extérieure du véhicule à la façon d'un couvercle.
